(19) Europäisches Patentamt
European Patent Office
Office européen des brevets

(11) **EP 2 076 960 B1**

(12) **FASCICULE DE BREVET EUROPEEN**

(45) Date de publication et mention de la délivrance du brevet:
**04.12.2019 Bulletin 2019/49**

(21) Numéro de dépôt: **07802915.4**

(22) Date de dépôt: **27.08.2007**

(51) Int Cl.:
***H03C 3/22*** *(2006.01)*

(86) Numéro de dépôt international:
**PCT/EP2007/058876**

(87) Numéro de publication internationale:
**WO 2008/031717 (20.03.2008 Gazette 2008/12)**

(54) **OSCILLATEUR HYPERFRÉQUENCE EN TECHNOLOGIE DES CIRCUITS INTÉGRÉS**

INTEGRIERTE SCHALTUNGSTECHNOLOGIE VERWENDENDER MIKROWELLENOSZILLATOR

MICROWAVE OSCILLATOR USING INTEGRATED CIRCUIT TECHNOLOGY

(84) Etats contractants désignés:
**AT BE BG CH CY CZ DE DK EE ES FI FR GB GR HU IE IS IT LI LT LU LV MC MT NL PL PT RO SE SI SK TR**

(30) Priorité: **12.09.2006 FR 0607963**

(43) Date de publication de la demande:
**08.07.2009 Bulletin 2009/28**

(73) Titulaire: **United Monolithic Semiconductors S.A.
91401 Orsay Cedex (FR)**

(72) Inventeurs:
• **DOMNESQUE, Denis
91400 Orsay (FR)**
• **GOURDON, Cyril
92160 Antony (FR)**
• **SEVIN, Rémi
92700 Colombes (FR)**

(74) Mandataire: **Lucas, Laurent Jacques
Marks & Clerk France
Conseils en Propriété Industrielle
Immeuble Visium
22, Avenue Aristide Briand
94117 Arcueil Cedex (FR)**

(56) Documents cités:
**WO-A-02/27937        US-A- 5 576 713
US-A1- 2002 014 925    US-A1- 2002 089 387**

**Description**

L'invention concerne un oscillateur hyperfréquence en technologie des circuits intégrés et notamment les MMIC soit en langue anglaise « Monolithic Microwave Integrated Circuit » fonctionnant dans des gammes de fréquences comprises entre 1GHz et 100GHz.

Ces oscillateurs intégrés hyperfréquences sont utilisés pour des nombreuses applications en télécommunications, en radar et notamment dans le domaine des radars pour automobile. Dans les applications pour automobile un radar envoi une onde hyperfréquence qui se trouve réfléchie par une ou plusieurs cibles dont les distances et les vitesses pourront être déduites des retards et variations de phase mesurés sur le signal réfléchi.

La sensibilité est une performance fondamentale pour les radars, notamment pour les applications automobiles. Cette sensibilité est définie comme la capacité à détecter des cibles lointaines (ou à surface équivalente radar faible) ainsi que la capacité à discriminer des cibles proches entre elles.

Pour cela il faut que le spectre du signal de retour du radar soit le plus étroit possible autour de sa fréquence d'émission, ou exprimé autrement, la largeur de bande du signal à -3dB doit être la plus faible possible.

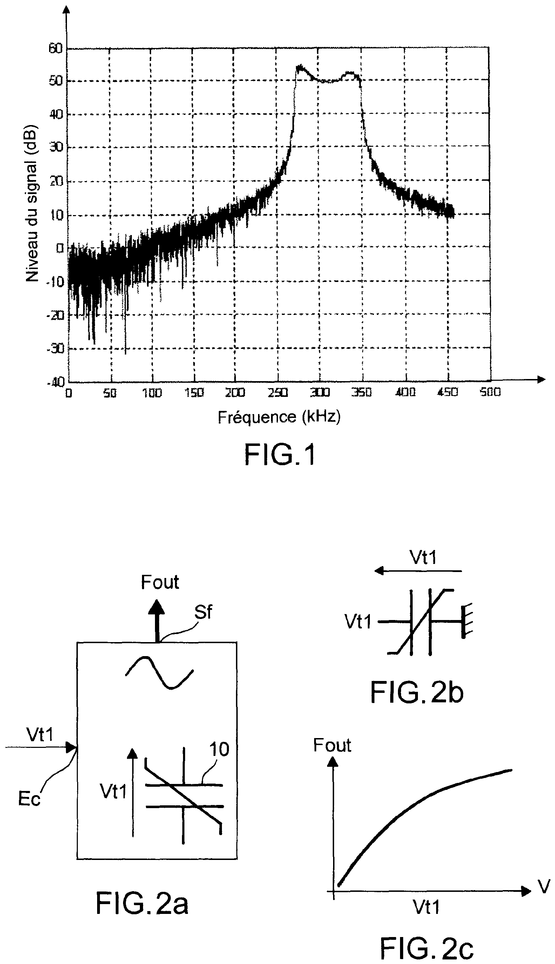

Par exemple, la figure 1 représente le spectre d'un signal reçu en bande de base (démodulé) par un radar de l'état de l'art sans aucun dispositif d'asservissement ou de précorrection de sa fréquence d'émission. En ordonnées le niveau relatif en dB du signal reçu et en abscisse la fréquence F en kHz. La largeur de bande est importante de l'ordre de 80kHz à -3dB par rapport au maximum de puissance du signal reçu. Une telle largeur de bande est incompatible avec la sensibilité nécessaire à une discrimination des cibles.

Il existe une relation directe entre la linéarité de l'oscillateur générateur de fréquence du radar et la sensibilité de celui-ci.

La figure 2a montre un schéma simplifié d'un oscillateur contrôlé en tension désigné aussi selon l'acronyme VCO, en langue anglaise « voltage controled oscillator ». Le VCO comporte une sortie Sf d'oscillation hyperfréquence de fréquence $F_{out}$ et une entrée de commande Ec de la fréquence du VCO.

Le changement de la fréquence $F_{out}$ du VCO est obtenu par l'évolution de la capacité d'un varactor 10 intégré dans le VCO. La variation de la tension de commande Vt1 appliquée au varactor, par l'entrée de commande Ec du VCO, entraîne une modification de la capacité du varactor et donc de la fréquence de résonance du VCO.

La figure 2b montre un schéma équivalent du varactor 10 du circuit d'oscillation du VCO de la figure 2a. Le schéma est équivalent à celui d'une capacité variable en fonction d'une tension de commande Vt1 appliquée à ses bornes.

La figure 2c illustre la variation de la fréquence du VCO ($F_{out}$) en fonction de la tension Vt1 de commande appliquée au varactor 10 de la figure 2a. Cette variation est non linéaire, ce qui présente l'inconvénient de réduire la sensibilité du radar.

L'oscillateur d'un radar automobile est commandé en fréquence par une entrée de contrôle assurant un changement de la fréquence d'émission de l'oscillateur mais aussi pour effectuer une modulation de la fréquence d'émission autour d'une fréquence centrale Fc.

Pour concevoir un radar de forte sensibilité, il faut une très bonne linéarité de la variation de la fréquence d'émission lors de la modulation de celle-ci par le contrôle en tension du VCO.

Les oscillateurs hyperfréquences de l'état de l'art en technologie des circuits intégrés ne sont pas suffisamment linéaires pour obtenir des bonnes performances dans les applications des radars automobiles. Pour améliorer cette linéarité des dispositifs externes au circuit intégré sont utilisés, tels qu'une boucle d'asservissement sur la fréquence de l'oscillateur ou bien une prédistorsion du signal de commande Vt1 du VCO. Ces solutions existantes pour améliorer la linéarité de l'oscillateur comportent des défauts :

- un coût du système de compensation supplémentaire,
- un niveau d'intégration de la partie génération de fréquence,
- une plus grande complexité de l'architecture du radar,
- une mauvaise pureté spectrale du radar vis à vis des régulations sur les émissions rayonnantes
- une bande passante de modulation de la source limitée par les dispositifs alternatifs d'amélioration de la linéarité,
- une distorsion du signal reçu par le radar en raison de la discrétisation des dispositifs alternatifs d'amélioration de la linéarité.

Un document US 2002/0089387 A1 décrit un oscillateur commandé en tension pour la modulation de fréquence.

Afin de pallier les inconvénients des oscillateurs hyperfréquences intégrés de l'état de l'art, l'invention propose un oscillateur hyperfréquence en technologie des circuits intégrés, l'oscillateur comportant une sortie hyperfréquence fournissant une fréquence d'oscillation $F_{out}$ fonction d'un signal de commande Vt,

caractérisé en ce que la fréquence d'oscillation $F_{out}$ peut être modulée autour d'une fréquence centrale Fc via deux entrées de commande de l'oscillateur, une première entrée de commande Ec1 attaquée par un premier signal de commande Vt1 fixant la fréquence centrale Fc de l'oscillateur et une deuxième entrée de commande Ec2 attaquée par un deuxième signal de commande Vt2 permettant la modulation linéaire de cette fréquence centrale Fc, le signal de commande Vt de l'oscillateur étant une fonction des deux signaux de commande Vt1 et Vt2, le signal de commande Vt appliqué au varactor de l'oscillateur résultant de la somme:

$$Vt = Vt1 - k.Vt2$$

k étant un paramètre arbitraire compris entre 0 et 1 sélectionné en fonction de l'application, k étant une fonction du deuxième signal Vt2, exprimé par k(Vt2), le signal de commande Vt étant alors :

$$Vt = Vt1 - F(Vt2)$$

avec F(Vt2) = k(Vt2).Vt2
la fonction F générant à partir de la deuxième tension de commande Vt2 la tension F(Vt2) = k(Vt2).Vt2.

Un principal objectif de l'invention est d'améliorer la linéarité de l'oscillateur contrôlé en tension.

D'autres objectifs sont une simplification de la réalisation de l'oscillateur ainsi qu'une baisse des coûts de fabrication.

La solution proposée par l'invention est basée sur l'ajout d'un système intégré analogique non linéaire sur le MMIC. Cette solution augmente la linéarité de la variation de fréquence en fonction d'une tension de contrôle destinée à moduler l'émission, et donc améliore la sensibilité du radar. Un oscillateur contrôlé en tension est linéaire lorsque sa fréquence de sortie est proportionnelle à sa tension de commande. De plus l'oscillateur ainsi réalisé conserve une autre tension de contrôle standard permettant de fixer la fréquence centrale de fonctionnement.

L'invention sera mieux comprise à l'aide d'exemples de réalisations d'oscillateurs hyperfréquences en technologie des MMIC en référence aux figures ci-annexées dans lesquelles :

- la figure 1, déjà décrite, représente le spectre d'un signal reçu par un radar de l'état de l'art ;
- la figure 2a, déjà décrite, montre un schéma simplifié d'un oscillateur contrôlé en tension ;
- la figure 2b, déjà décrite, montre un schéma équivalent du varactor du circuit d'oscillation du VCO de la figure 2a ;
- la figure 2c, déjà décrite, illustre la variation de la fréquence du VCO en fonction de la tension Vt1 de commande appliquée au varactor de la figure 2a ;
- la figure 3a montre une première réalisation d'un VCO selon l'invention ;
- la figure 3b montre un pont diviseur de tension pour l'obtention du paramètre k ;
- la figure 3c montre la tension Vt appliquée aux bornes de la capacité du varactor du VCO de la figure 3a ;
- la figure 3d montre la variation de la fréquence d'oscillation du VCO en fonction de la tension Vt1 pour une tension Vt2 constante ;
- la figure 3e montre la variation de fréquence d'oscillation $F_{out}$ en sortie du VCO en fonction de la deuxième tension de commande Vt2 pour une tension Vt1 constante ;
- la figure 4a montre une autre réalisation du VCO selon l'invention ;
- la figure 4b montre la tension Vt appliquée aux bornes de la capacité du varactor du VCO de la figure 4a ;
- la figure 4c montre la variation de fréquence du VCO de la figure 4a en fonction de la deuxième tension Vt2 tension appliquée au varactor avec Vt1 constante ;
- la figure 5a montre la tension obtenue F(Vt2)=k(Vt2).Vt2 à partir de la deuxième tension de commande Vt2 en sortie de la fonction F ;
- la figure 5b montre la tension appliquée à une des bornes de la capacité du varactor soit k(Vt2).Vt2 en fonction de la deuxième tension de commande Vt2 ;
- la figure 5c montre une réalisation pratique de la fonction F et
- la figure 6 montre le spectre du signal reçu par un radar comportant un VCO selon l'invention.

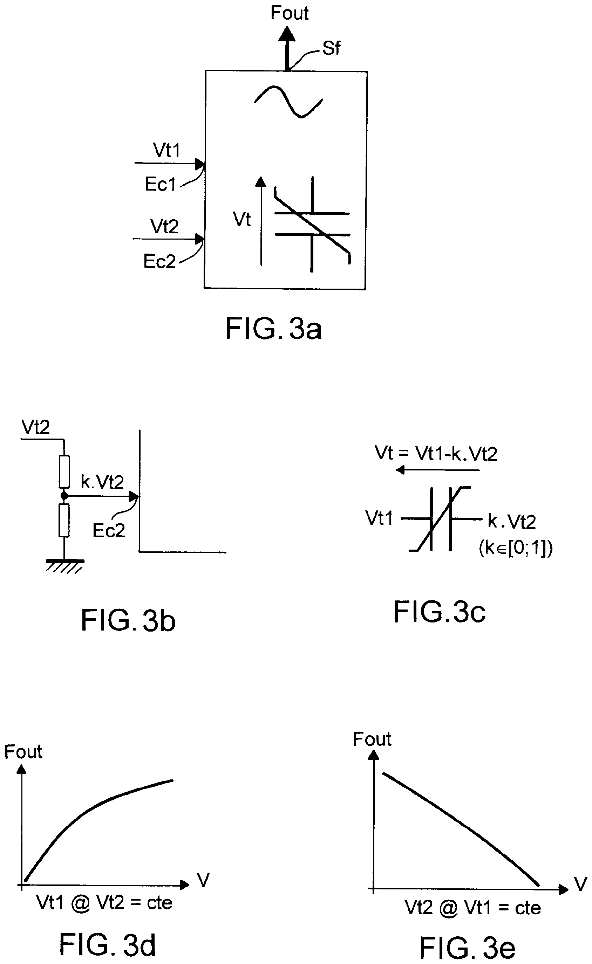

La figure 3a montre une réalisation d'un VCO comportant, comme dans le VCO de la figure 2a, la sortie Sf d'oscillation hyperfréquence de fréquence $F_{out}$ et une entrée de commande Ec1 de la fréquence du VCO et selon une principale caractéristique de l'invention, une deuxième entrée Ec2 pour l'application au VCO d'un deuxième signal de commande Vt2.

Le changement de la fréquence $F_{out}$ du VCO est obtenu sous l'effet de la variation de la tension Vt de commande appliquée au varactor (10) du VCO.

Selon une autre caractéristique de cette invention, le signal de commande Vt appliqué au varactor du VCO résulte de la somme :

3

$$Vt = Vt1 - k.Vt2$$

Dans cette première réalisation k est un paramètre compris entre 0 et 1, sélectionné en fonction de l'application.

La valeur de k peut, par exemple, être obtenue par un simple pont diviseur de tension. La figure 3b montre un tel pont diviseur de tension pour l'obtention du paramètre k comportant deux résistances R1 et R2 en série, la tension k.Vt2 est obtenue au point de connexion des deux résistances en série R1, R2.

La figure 3c montre la tension Vt appliquée aux bornes de la capacité du varactor du VCO de la figure 3a, la tension Vt1 à l'une des bornes et la tension k.Vt2 à l'autre borne de la capacité du varactor.

La figure 3d montre la variation de la fréquence d'oscillation du VCO ($F_{out}$) en fonction de la tension Vt1 pour une tension Vt2 constante. On constate que cette variation est similaire à celle du VCO de l'état de l'art de la figure 2a. Donc cette configuration à deux tensions de commande Vt1 et Vt2 ne perturbe pas le fonctionnement décrit pour le VCO de l'état de l'art de la figure 2a. Ce qui permet en outre de conserver une large plage de fonctionnement en fréquence.

La figure 3e montre la variation de fréquence d'oscillation $F_{out}$ en sortie du VCO en fonction de la deuxième tension de commande Vt2 pour la première tension Vt1 de commande constante.

On remarque sur la figure 3e que la caractéristique de pente est inversée, et plus le coefficient k est petit devant 1, plus la variation de fréquence en fonction de Vt2 est linéaire. On réalise en fait une variation de la fréquence $F_{out}$ plus ou moins importante selon la valeur de k autour de $F_{out}$ (Vt1=cte) en fonction de Vt2. La pente de la courbe de la figure 3e varie en effet d'autant moins par rapport à sa valeur moyenne que la plage de variation considérée est petite.

Ce dispositif procure une large plage de fonctionnement pour le radar en fonction de Vt1, et un mode de fonctionnement en fonction de Vt2 plus approprié à la modulation en fréquence du radar.

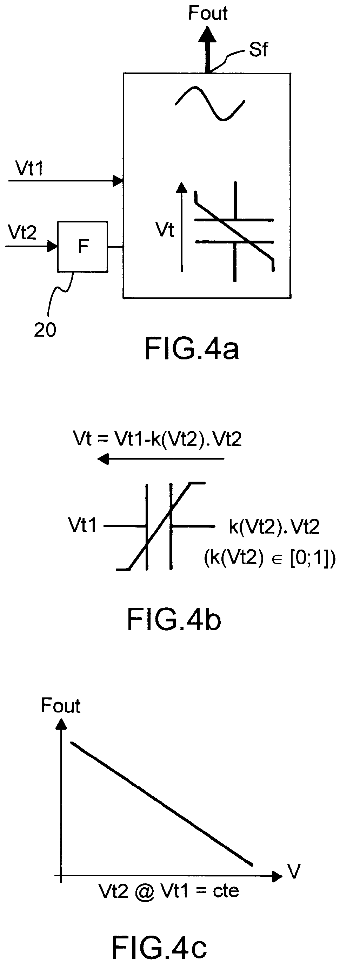

La figure 4a montre une réalisation du VCO selon l'invention.

Dans cette réalisation du VCO, k est une fonction de la deuxième tension Vt2, notée k(Vt2), la valeur de cette fonction étant comprise entre 0 et 1. La tension de commande Vt résultante appliquée au varactor du VCO sera exprimée par :

$$Vt = Vt1 - k(Vt2).Vt2$$

ou exprimé autrement :

$$Vt = Vt1 - F(Vt2)$$

avec F(Vt2) = k(Vt2).Vt2

Dans cette autre réalisation la fonction F génère, à partir de la deuxième tension de commande Vt2, la tension F(Vt2) = k(Vt2).Vt2.

La figure 4b montre la tension Vt appliquée aux bornes de la capacité du varactor du VCO de la figure 4a, la tension Vt1 à l'une des bornes et la tension k(Vt2).Vt2 à l'autre borne de la capacité du varactor.

La totalité de l'invention est utilisée dans cette réalisation de la figure 4a. avec l'ajout de la deuxième tension de contrôle Vt2 à travers la fonction F. La fonction k dépend dans cette autre réalisation de la tension Vt2.

La fonction F fournissant la tension F(Vt2) = k(Vt2).Vt2 au varactor est une fonction non linéaire permettant de compenser de manière analogique la variation de pente de la fréquence $F_{out}$ en fonction de la deuxième tension Vt2 avec la première tension Vt1 constante.

La figure 4c montre la variation de fréquence du VCO de la figure 4a $F_{out}$ en fonction de la deuxième tension Vt2 appliquée au varactor avec Vt1 constante.

On obtient donc comme illustré à la figure 4c une pente quasi constante de $F_{out}$ en fonction de Vt2 à Vt1 constante.

Cet oscillateur contrôlé en tension, selon l'invention, procure toujours une large plage de fonctionnement pour le radar en fonction de Vt1, et un mode de fonctionnement en fonction de Vt2 encore plus approprié à la modulation de la fréquence du radar, car ayant une linéarité accrue de F(Vt2) à Vt1 constante. Ce qui améliore directement la sensibilité du radar sans ajout de compensation externe au VCO.

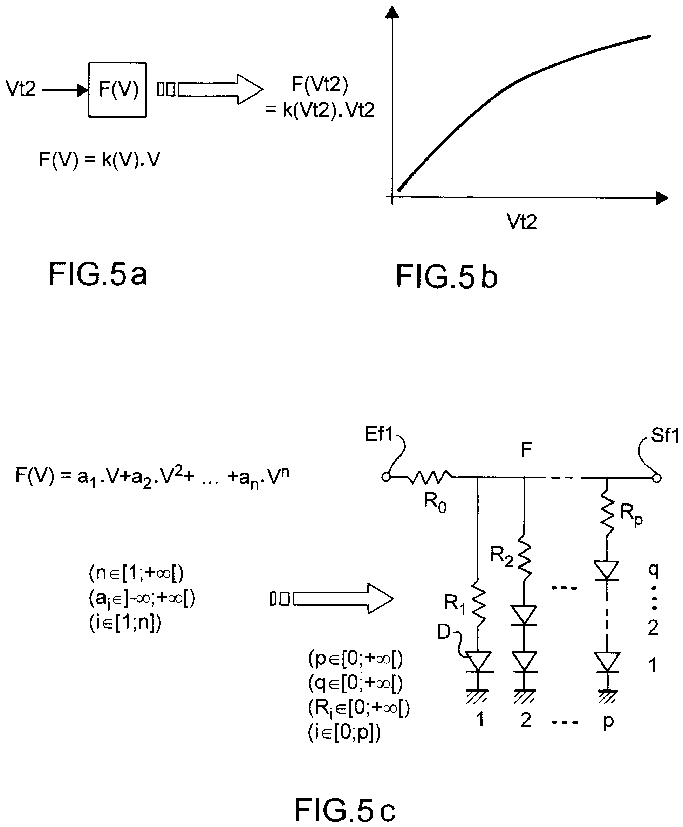

La figure 5a montre la tension obtenue F(Vt2)=k(Vt2).Vt2 à partir de la deuxième tension de commande Vt2 en sortie de la fonction F et la figure 5b la courbe de la tension appliquée à une des bornes de la capacité du varactor soit k(Vt2).Vt2 en fonction de la deuxième tension de commande Vt2.

La fonction F est typiquement non linéaire.

Dans une gamme de tension Vt2 donnée et finie, la tension F(Vt2) peut être décrite par la série :

$$F(Vt2) = a_1.Vt2 + a_2.Vt2^2 + a_3.Vt2^3 + \ldots\ a_i.Vt2^i \ldots\ a_n.Vt2^n$$

avec

$n \in \{1;+\infty\}$

$a_i \in \{-\infty;+\infty\}$

$i \in \{1;n\}$

n et i sont des entiers positifs. $a_i$ est un réel.

La figure 5c montre une réalisation pratique de la fonction F à partir d'éléments linéaires comme des résistances, et d'éléments non linéaires comme des diodes.

Dans cet exemple, la fonction F est réalisée par un quadripôle comportant :

- une entrée Ef1 et une sortie Sf1 reliées par une résistance R0. La sortie Sf1 est reliée à un potentiel de référence, par exemple une masse M, par p réseaux (0, 1, 2, ..i,...p) en parallèles, chacun des réseaux comportant une résistance R1, R2, R3,...Ri,....Rp en série avec un nombre j de diodes D, j étant compris entre 0 et q.

Par exemple, dans cette réalisation, le réseau de rang i=1 comporte une résistance R1 en série avec une diode D, le réseau de rang i=2 comporte une résistance R2 en série avec deux diodes D, le réseau de rang i comporte une résistance Ri en série avec i diodes D et ainsi de suite.

Bien entendu le nombre de diodes D dans un réseau peut être différent du rang du réseau. Par exemple le réseau de rang i peut comporter une résistance Ri en série avec j diodes D.

Bien entendu en théorie le nombre de réseau n'est pas limité et on peut exprimer que :

$$p \in \{1;+\infty\}$$

$$q \in \{0;+\infty\}$$

$$Ri \in \{0;+\infty\}$$

$$i \in \{0; p\}$$

$$j \in \{0; q\}$$

p, q, i, j sont des entiers positifs . Ri est un réel positif.

Cependant la fonction peut aussi être réalisée à partir de tout élément ayant un comportement non linéaire de son courant en fonction de la tension qui lui est appliquée (par exemple des transistors, ...).

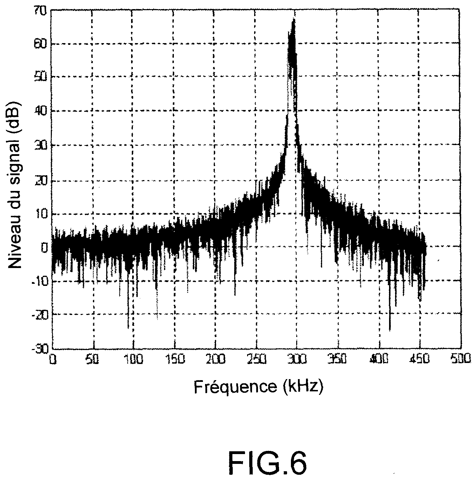

La figure 6 montre le spectre du signal reçu en bande de base (démodulé) par un radar comportant un VCO selon l'invention à comparer au spectre du signal de la figure 1 d'un radar ne comportant pas un tel VCO. La largeur de bande à -3dB de la puissance maximum du signal reçu par le radar comportant le VCO selon l'invention est de 10kHz à comparer à celle du radar de l'état de l'art qui présente une largeur beaucoup plus large de l'ordre de 80kHz.

## Revendications

**1.** Oscillateur hyperfréquence en technologie des circuits intégrés, l'oscillateur comportant une sortie hyperfréquence (Sf) fournissant une fréquence d'oscillation $F_{out}$ fonction d'un signal de commande Vt, le changement de la fréquence $F_{out}$ de l'oscillateur étant obtenu sous l'effet de la variation de la tension Vt de commande appliquée à un varactor (10) de l'oscillateur (VCO),
**caractérisé en ce que** la fréquence d'oscillation $F_{out}$ peut être modulée autour d'une fréquence centrale Fc via deux entrées de commande de l'oscillateur, l'oscillateur comportant une première entrée de commande Ec1 attaquée par un premier signal de commande Vt1 fixant la fréquence centrale Fc de l'oscillateur et une deuxième entrée de commande Ec2 attaquée par un deuxième signal de commande Vt2 permettant la modulation linéaire de cette fréquence centrale Fc, le signal de commande Vt de l'oscillateur étant une fonction des deux signaux de commande Vt1 et Vt2 le signal de commande Vt appliqué au varactor de l'oscillateur résultant de la somme :

$$Vt = Vt1 - k.Vt2$$

k étant un paramètre compris entre 0 et 1 sélectionné en fonction de l'application,
k étant une fonction du deuxième signal Vt2, exprimé par k(Vt2), le signal de commande Vt étant alors :

$$Vt = Vt1 - F(Vt2)$$

avec F(Vt2) = k(Vt2).Vt2
la fonction F générant à partir de la deuxième tension de commande Vt2 la tension F(Vt2) = k(Vt2).Vt2.

2. Oscillateur selon la revendication 1, **caractérisé en ce que** la fonction F est réalisée à partir d'éléments linéaires comme des résistances (R0, R1, R2,...Rp), et d'éléments non linéaires comme des diodes (D) ou des transistors.

3. Oscillateur selon l'une quelconque des revendications précédentes, **caractérisé en ce que**, dans une gamme de tensions de commande Vt2 donnée et finie, la tension F(Vt2) peut être décrite par la série :

$$F(Vt2) = a_1.Vt2 + a_2.Vt2^2 + a_3.Vt2^3 + \dots \ a_i.Vt2^i \ \dots \ a_n.Vt2^n$$

avec $n \in \{1;+\infty\}$
$a_i \in \{-\infty;+\infty\}$
$i \in \{1;n\}$
n et i étant des entiers positifs. $a_i$ est un réel.

4. Oscillateur selon la revendication 3, **caractérisé en ce que** la fonction F est réalisée par un quadripôle comportant :

- une entrée Ef1 et une sortie Sf1 reliées par une résistance R0, la sortie Sf1 étant reliée à un potentiel de référence, par exemple une masse M, par p réseaux (0, 1, 2, ..i,...p) en parallèles, chacun des réseaux comportant une résistance R1, R2, R3,...Ri,....Rp en série avec un nombre j de diodes D, j étant compris 0 et q avec

$$p \in \{1;+\infty\}$$

$$q \in \{0;+\infty\}$$

$$Ri \in \{0;+\infty\}$$

$$i \in \{0; p\}$$

$$j \in \{0; q\}$$

p, q, i, j sont des entiers positifs . Ri est un réel positif.

**Patentansprüche**

1. Integrierte Schaltungstechnologie verwendender Mikrowellenoszillator, wobei der Oszillator einen Mikrowellenausgang (Sf) besitzt, welcher eine Oszillationsfrequenz $F_{out}$ als Funktion eines Steuersignals Vt besitzt, wobei die Änderung der Frequenz $F_{out}$ des Oszillators unter Einwirkung der Variation der Steuerspannung Vt, welche an einen Varaktor (10) des Oszillators (VCO) angelegt wird, erzielt wird, **dadurch gekennzeichnet, dass** die Oszillationsfrequenz $F_{out}$ um eine Mittelfrequenz Fc über zwei Steuereingänge des Oszillators moduliert werden kann, wobei der Oszillator einen ersten Steuereingang Ec1 besitzt, welcher durch ein erstes Steuersignal Vt1 angesprochen wird, welches die Mittelfrequenz Fc des Oszillators festlegt, und einen zweiten Steuereingang Ec2, welcher durch ein zweites Steuersignal Vt2 angesprochen wird, welches die lineare Modulation dieser Mittelfrequenz Fc ermöglicht, wobei das Steuersignal Vt des Oszillators eine Funktion der beiden Steuersignale Vt1 und Vt2 ist, wobei das Steuersignal Vt, welches an den Varaktor des Oszillators angelegt wird, aus folgender Summe resultiert:

$$Vt = Vt1 - k.Vt2$$

   wobei k ein Parameter ist, welcher zwischen 0 und 1 liegt, welcher angesichts der Anwendung gewählt wird, wobei k eine Funktion des zweiten Signals Vt2 ist, ausgedrückt durch k(Vt2), wobei das Steuersignal Vt dann wie folgt lautet:

$$Vt = Vt1 - F(Vt2)$$

   wobei $F(Vt2) = k(Vt2).Vt2$
   wobei die Funktion F anhand der zweiten Steuerspannung Vt2 die Spannung $F(Vt2) = k(Vt2).Vt2$ erzeugt.

2. Oszillator nach Anspruch 1, **dadurch gekennzeichnet, dass** die Funktion F anhand von linearen Elementen wie Widerständen (R0, R1, R2,...Rp) und von nichtlinearen Elementen wie Dioden (D) oder Transistoren ausgeführt wird.

3. Oszillator nach einem der vorhergehenden Ansprüche, **dadurch gekennzeichnet, dass** in einem gegebenen und endlichen Bereich von Steuerspannungen Vt2 die Spannung F(Vt2) durch folgende Serie beschrieben werden kann:

$$F(Vt2) = a_1.Vt2 + a_2.Vt2^2 + a_3.Vt2^3 +.... a_i.Vt2^i ... a_n.Vt2^n$$

   wobei $n \in \{1;+\infty\}$
   $a_i \in \{-\infty;+\infty\}$
   $i \in \{1;n\}$
   wobei n und i positive Ganzzahlen sind. $a_i$ ist eine reelle Zahl.

4. Oszillator nach Anspruch 3, **dadurch gekennzeichnet, dass** die Funktion F durch einen Vierpol ausgeführt wird, welcher Folgendes beinhaltet:

   - einen Eingang Ef1 und einen Ausgang Sf1, welche durch einen Widerstand R0 verbunden sind, wobei der Ausgang Sf1 mit einem Referenzpotenzial verbunden ist, beispielsweise einer Masse M, parallel durch p Netze (0, 1, 2, ..i,...p), wobei jedes der Netze einen Widerstand R1, R2, R3,...Ri,....Rp in Reihe mit einer Anzahl j von Dioden D beinhaltet, wobei j zwischen 0 und q beträgt, wobei

   $p \in \{1;+\infty\}$

   $q \in \{0;+\infty\}$
   $Ri \in \{0;+\infty\}$

   $i \in \{0;p\}$
   $j \in \{0;q\}$
   p, q, i, j positive Ganzzahlen sind. Ri ist eine positive reelle Zahl.

**Claims**

1. Microwave oscillator using integrated circuit technology, the oscillator comprising a microwave output (Sf) providing an oscillation frequency $F_{out}$ as a function of a control signal Vt, the change in the frequency $F_{out}$ of the oscillator being achieved as a result of variation of the control voltage Vt applied to a varactor (10) of the oscillator (VCO), **characterised in that** the oscillation frequency $F_{out}$ can be modulated around a central frequency Fc via two oscillator control inputs, the oscillator comprising a first control input Ec1 driven by a first control signal Vt1 fixing the central frequency Fc of the oscillator and a second control input Ec2 driven by a second control signal Vt2 allowing for the linear modulation of this central frequency Fc, the control signal Vt of the oscillator being a function of the two control signals Vt1 and Vt2, the control signal Vt applied to the varactor of the oscillator resulting in the sum:

$$Vt = Vt1 - k.Vt2$$

k being a parameter between 0 and 1 selected based on the application,
k being a function of the second signal Vt2, expressed by k(Vt2), the control signal Vt then being:

$$Vt = Vt1 - F(Vt2)$$

with F(Vt2) = k(Vt2).Vt2
the function F generating from the second control voltage Vt2 the voltage F(Vt2) = k(Vt2).Vt2.

2. Oscillator according to claim 1, **characterised in that** the function F is implemented from linear elements such as resistors (R0, R1, R2,...Rp), and non-linear elements such as diodes (D) or transistors.

3. Oscillator according to any one of the previous claims, **characterised in that**, in a given and finite control voltage range Vt2, the voltage F(Vt2) can be described by the series:

$$F(Vt2) = a_1.Vt2 + a_2.Vt2^2 + a_3.Vt2^3 + .... \ a_i.Vt2^i \ ..... \ a_n.Vt2^n$$

with $n \in \{1;+\infty\}$
$a_i \in \{-\infty;+\infty\}$
$i \in \{1;n\}$
n and i being positive integers. $a_i$ being a real number.

4. Oscillator according to claim 3, **characterized in that** the function F is implemented by a quadrupole comprising:

   - an input Ef1 and an output Sf1 linked by a resistor R0, the output Sf1 being linked to a reference potential, for example a mass M, by p arrays (0, 1, 2, ..i,...p) in parallel, each array comprising a resistor R1, R2, R3,...Ri,....Rp in series with a number j of diodes D, j being between 0 and q with

$$p \in \{1;+\infty\}$$

$$q \in \{0;+\infty\}$$

$$Ri \in \{0;+\infty\}$$

$$i \in \{0; p\}$$

$$j \in \{0; q\}$$

p, q, i, j are positive integers. Ri is a positive real number.

FIG.1

FIG.2a

FIG.2b

FIG.2c

Fout

Sf

Vt1

Ec1

Vt2

Ec2

Vt

FIG. 3a

Vt2

k.Vt2

Ec2

FIG. 3b

$$Vt = Vt1 - k.Vt2$$

$$Vt1 \qquad k.Vt2$$
$$(k \in [0;1])$$

FIG. 3c

Fout

V

Vt1 @ Vt2 = cte

FIG. 3d

Fout

V

Vt2 @ Vt1 = cte

FIG. 3e

Fout

Sf

Vt1

Vt2

F

Vt

20

## FIG.4a

$$Vt = Vt1 - k(Vt2) \cdot Vt2$$

Vt1

$k(Vt2) \cdot Vt2$

$(k(Vt2) \in [0;1])$

## FIG.4b

Fout

V

Vt2 @ Vt1 = cte

## FIG.4c

$F(V) = k(V).V$

$$F(Vt2) = k(Vt2).Vt2$$

**FIG.5a**

**FIG.5b**

$$F(V) = a_1.V + a_2.V^2 + \ldots + a_n.V^n$$

$(n \in [1; +\infty[)$
$(a_i \in ]-\infty; +\infty[)$
$(i \in [1;n])$

$(p \in [0; +\infty[)$
$(q \in [0; +\infty[)$
$(R_i \in [0; +\infty[)$
$(i \in [0;p])$

**FIG.5c**

13

FIG.6

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20020089387 A1